# EUROPEAN PATENT APPLICATION

(11) **EP 3 366 992 A1**
(43) Date of publication of application: **29.08.2018**
(21) Application number: 15895861.1
(22) Date of filing: 09.11.2015
(51) Int. Cl.: F21V 31/00, F21Y 115/10

(54) **DEEPWATER LED LIGHTING SEALING STRUCTURE**

(30) Priority: 23.10.2015 CN 201510695844
(71) Applicant: Li, Feng, Shenzhen, Guangdong 518000 (CN)
(72) Inventor: Li, Feng, Shenzhen, Guangdong 518000 (CN)
(74) Representative: Lang, Christian
(86) International application number: PCT/CN2015/094124
(87) International publication number: WO 2017/067027

(57) **Abstract**

A closing structure for a waterproof LED lamp contains: a first casing (10), a light power source (30), and a second casing (20). The light power source (30) is housed in an accommodation groove of a bottom of the first casing (10), and the first casing (10) is in connection with the second casing (20). A first closing film (41) is injection molded on a peripheral side of a first connection surface of the first casing (10) facing to the second casing (20), and a second closing film (42) is injection molded on a peripheral side of a second connection surface of the second casing (20) facing the first casing (10).

## Description

### FIELD OF THE INVENTION

The present invention relates to a closing structure for a waterproof LED lamp which avoids water flowing into the waterproof LED lamp at pressure of 55MPa.

### BACKGROUND OF THE INVENTION

A conventional waterproof LED lamp is applicable for illumination under water, so a closing structure used to avoid water flowing into the waterproof LED is important.

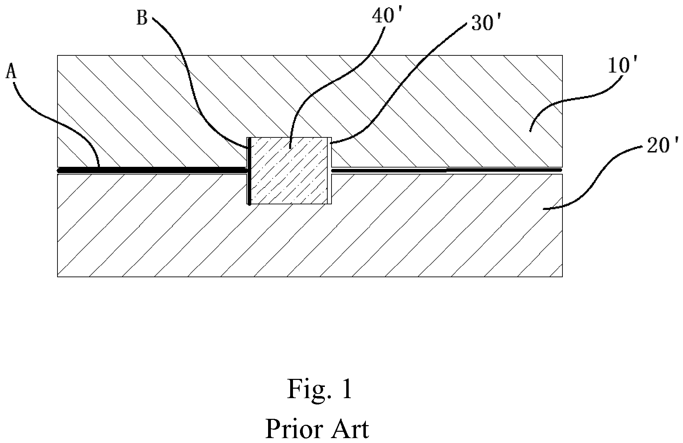

Referring to FIG. 1, a conventional closing structure for a waterproof LED lamp contains: a first casing 10' and a second casing 20' connected with the first casing 10', wherein a connection slit A is defined between the first casing 10' and the second casing 20'. To avoid water flowing into the slit A, two waterproof slots 30' are arranged in the connection slit A, and a sealing rubber ring 40' is retained in the two waterproof slots 30'. However, a gap B among the sealing rubber ring 40' and the two waterproof slots 30' forms, so water flows into the gap B.

The present invention has arisen to mitigate and/or obviate the afore-described disadvantages.

### SUMMARY OF THE INVENTION

The primary objective of the present invention is to provide a closing structure for a waterproof LED lamp which avoids water flowing into the waterproof LED lamp at pressure of 55MPa.

To obtain above-mentioned objective, a closing structure for a waterproof LED lamp provided by the present invention contains: a first casing, a light power source, and a second casing.

The light power source is housed in an accommodation groove of a bottom of the first casing, and the first casing is in connection with the second casing. A first closing film is injection molded on a peripheral side of a first connection surface of the first casing facing to the second casing, and a second closing film is injection molded on a peripheral side of a second connection surface of the second casing facing the first casing.

Preferably, a size and a profile of the first closing film correspond to those of the first casing, and a size and a profile of the second closing film correspond to those of the second casing.

Preferably, the first closing film matingly contacts with the first connection surface of the first casing, and the second closing film matingly contacts with the second connection surface of the second casing.

Preferably, each of the first closing film and the second closing film is a silicone rubber film with a thickness of 0.2 mm.

Preferably, a rectangular locking structure is arranged on a peripheral side of the first connection surface of the first casing and on a peripheral side of the second connection surface of the second casing, respectively.

Preferably, a trapezoidal locking structure is arranged on a peripheral side of the first connection surface of the first casing and on a peripheral side of the second connection surface of the second casing, respectively.

Preferably, the rectangular locking structure includes multiple first protrusions and multiple first recesses, each of the multiple first protrusions is in a rectangle shape, and each of the multiple first recesses is in a rectangle shape, wherein any two adjacent of the multiple first protrusions are separated by each of the multiple first recesses, and any two adjacent of the multiple first recesses are separated by each of the multiple first protrusions. Some of the multiple first protrusions on the first casing retain with some of the multiple first recesses on the second casing, and the other of the multiple first protrusions on the second casing retain with the other of the multiple first recesses on the first casing.

Preferably, the trapezoidal locking structure includes multiple first protrusions and multiple first recesses, each of the multiple first protrusions is in a trapezoid shape, and each of the multiple first recesses is in a trapezoid shape, wherein any two adjacent of the multiple first protrusions are separated by each of the multiple first recesses, and any two adjacent of the multiple first recesses are separated by each of the multiple first protrusions. Some of the multiple first protrusions on the first casing retain with some of the multiple first recesses on the second casing, and the other of the multiple first protrusions on the second casing retain with the other of the multiple first recesses on the first casing.

Preferably, each of multiple coupling orifices passes through said each first protrusion, and the multiple coupling orifices are coaxial so that a fitting shaft inserts through the multiple coupling orifices, thus connecting the first casing and the second casing together.

A method of making a closing structure for a waterproof LED lamp contains steps of:
providing a first casing, a light power source, and a second casing;
housing the light power source in an accommodation groove of the first casing; and
connecting the first casing with the second casing;
characterized in that
the first casing has a first closing film injection molded on a peripheral side of a first connection surface thereof, and the second casing has a second closing film injection molded on a peripheral side of a second connection surface thereof.

Preferably, a size and a profile of the first closing film correspond to those of the first connection surface of the first casing, such that the first closing film matingly contacts with the first connection surface of the first casing, and a size and a profile of the second closing film correspond to those of the second connection surface of the second casing, hence the second closing film matingly contacts with the second connection surface of the second casing.

Preferably, the second casing is placed into a first holder in a vacuum condition, the second connection surface of the second casing faces upwardly, and a mold is mounted on the second connection surface of the second casing, wherein the mold has at least one feeding hole defined on a top thereof so that liquid silicone rubber is fed into the mold from the at least one feeding holes, and the liquid silicone rubber is baked after conducting electricity to the mold, then the second closing film is injection molded on the second connection surface of the second casing, wherein a profile of the mold corresponds to that the second casing, and a distance between the mold and the second casing is 0.2 mm.

Preferably, in a vacuum condition, the first casing is placed into a second holder, and a mold is fixed on the first casing, the mold has at least one feeding hole defined on a top thereof so that liquid silicone rubber is fed into the mold from the at least one feeding hole, wherein the liquid silicone rubber is baked after conducting electricity to the mold, and the liquid silicone rubber solidifies to form the first closing film on the peripheral side of the first connection surface of the first casing. Preferably, the profile of the mold corresponds to that the first casing, and a distance between the mold and the first casing is 0.2 mm.

Preferably, when the first casing and the second casing are connected together, a thickness of the first closing film and the second closing film is 0.2 mm to 0.4 mm.

### BRIEF DESCRIPTION OF THE DRAWINGS

FIG. 1 is a cross sectional view of a conventional closing structure for a waterproof LED lamp.
FIG 2 is a perspective view showing the exploded components of a closing structure for a waterproof LED lamp according to a first embodiment of the present invention.
FIG 3 is a perspective view showing the assembly of a part of the closing structure for the waterproof LED lamp according to the first embodiment of the present invention.

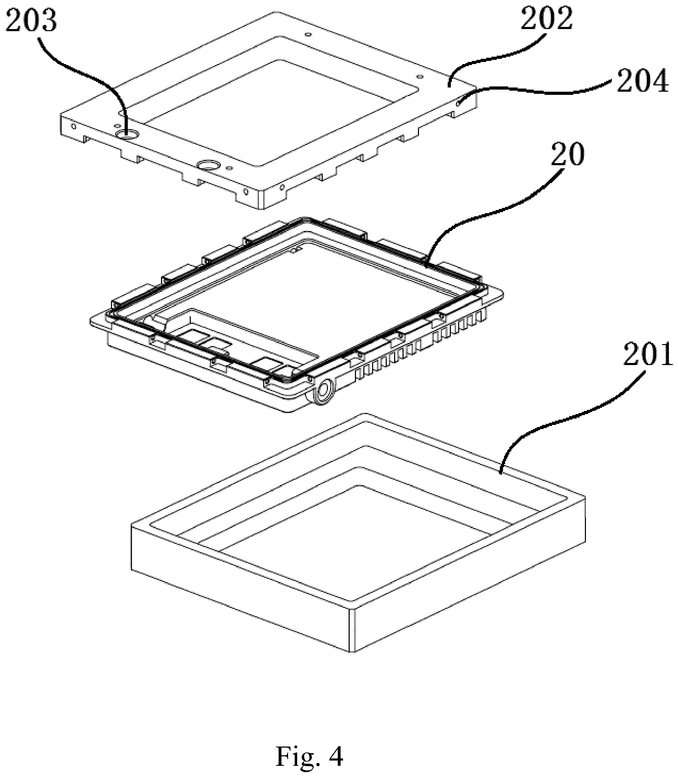

FIG 4 is a perspective view showing the exploded components of a part of the closing structure for the waterproof LED lamp according to the first embodiment of the present invention.
FIG 5 is a perspective view showing the assembly of a part of the closing structure for the waterproof LED lamp according to a second embodiment of the present invention.

### DETAILED DESCRIPTION OF THE PREFERRED EMBODIMENTS

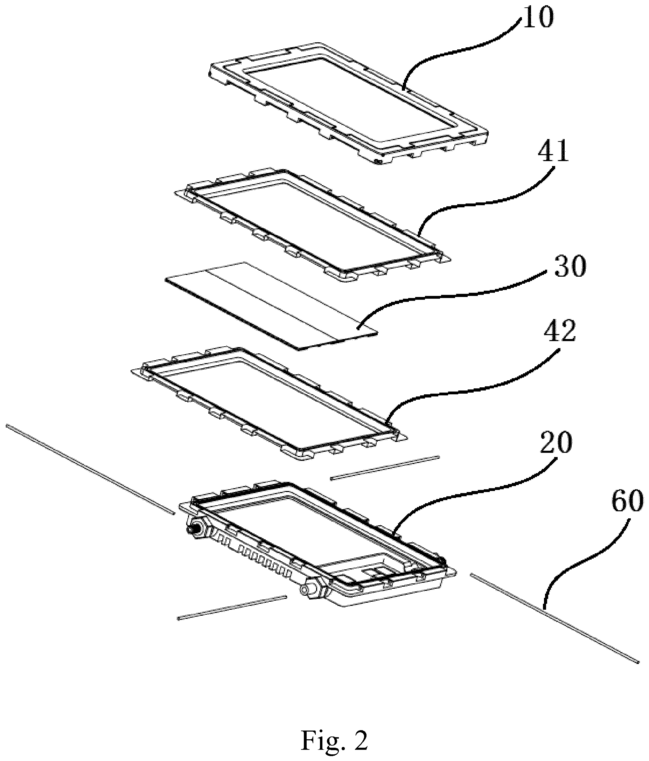

With reference to FIG. 2, a closing structure for a waterproof LED lamp according to a first embodiment of the present invention comprises: a first casing 10, a light power source 30, and a second casing 20.

The light power source 30 is housed in an accommodation groove of a bottom of the first casing 10, and the first casing 10 is in connection with the second casing 20. A first closing film 41 is injection molded on a peripheral side of a first connection surface of the first casing 10 facing to the second casing 20, and a second closing film 42 is injection molded on a peripheral side of a second connection surface of the second casing 20 facing the first casing 10, wherein a size and a profile of the first closing film 41 correspond to those of the first casing 10, such that the first closing film 41 matingly contacts with the first connection surface of the first casing 10, and a size and a profile of the second closing film 42 correspond to those of the second casing 20, hence the second closing film 42 matingly contacts with the second connection surface of the second casing 20.

Each of the first closing film 41 and the second closing film 42 is a silicone rubber film with a thickness of 0.2 mm.

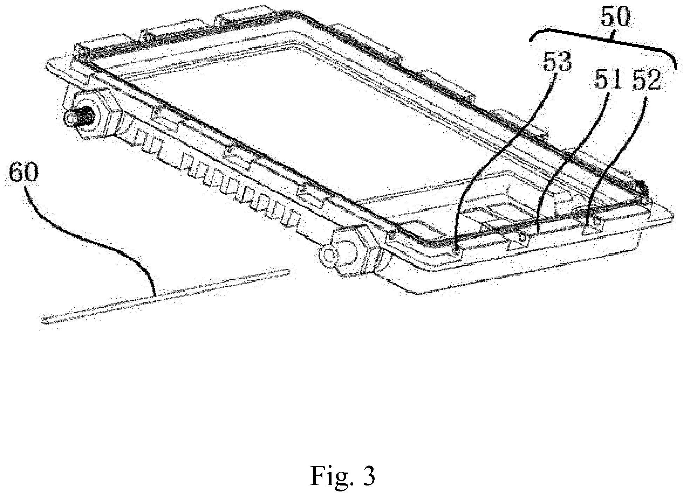

Referring to FIG. 3, a rectangular locking structure 50 is arranged on a peripheral side of the first connection surface of the first casing 10 and on a peripheral side of the second connection surface of the second casing 20, respectively, wherein the locking structure 50 includes multiple first protrusions 51 and multiple first recesses 52, each of the multiple first protrusions 51 is in a rectangle shape, and each of the multiple first recesses 52 is in a rectangle shape, wherein any two adjacent of the multiple first protrusions 51 are separated by each of the multiple first recesses 52, and any two adjacent of the multiple first recesses 52 are separated by each of the multiple first protrusions 51. Each of multiple coupling orifices 53 passes through said each first protrusion 51, and the multiple coupling orifices 53 are coaxial so that a fitting shaft 60 inserts through the multiple coupling orifices 53, thus connecting the first casing 10 and the second casing 20 together. When the first casing 10 and the second casing 20 are connected together, a thickness of the first closing film 41 and the second closing film 42 is 0.2 mm to 0.4 mm.

Preferably, some of the multiple first protrusions 51 on the first casing 10 retain with some of the multiple first recesses 52 on the second casing 20, and the other of the multiple first protrusions 51 on the second casing 20 retain with the other of the multiple first recesses 52 on the first casing 10, thus securely fixing the first casing 10 and the second casing 20 together.

A method of making the closing structure for the waterproof LED lamp contains steps of: providing the first casing 10, the light power source 30, and the second casing 20; housing the light power source 30 in the accommodation groove of the first casing 10; and connecting the first casing 10 with the second casing 20, wherein the first casing 10 has the first closing film 41 injection molded on the peripheral side of the first connection surface thereof, and the second casing 20 has the second closing film 42 injection molded on the peripheral side of the second connection surface thereof, wherein the size and the profile of the first closing film 41 correspond to those of the first connection surface of the first casing 10, such that the first closing film 41 matingly contacts with the first connection surface of the first casing 10, and the size and the profile of the second closing film 42 correspond to those of the second connection surface of the second casing 20, hence the second closing film 42 matingly contacts with the second connection surface of the second casing 20.

As desiring to injection mold the second closing film 42 on the second casing 20, the second casing 20 is placed into a first holder 201 in a vacuum condition, the second connection surface of the second casing 20 faces upwardly, and a mold 202 is mounted on the second connection surface of the second casing 20. The mold 202 has at least one feeding hole 203 defined on a top of the mold 202 so that liquid silicone rubber is fed into the mold 20 from the at least one feeding holes 203, and the liquid silicone rubber is baked after conducting electricity to the mold 202, then the second closing film 42 is injection molded on the second connection surface of the second casing 20. Preferably, a profile of the mold 202 corresponds to that the second casing 20, and a distance between the mold 202 and the second casing 20 is 0.2 mm.

The first holder 201 has a hollow chamber defined on a central portion thereof so as to house the second casing 20, and the second closing film 42 is injection molded on the second connection surface of the second casing 20.

The profile of the mold 202 corresponds to that of the second casing 20 so that the mold 202 contacts with the second casing 20 matingly, wherein the mold 20 includes multiple second protrusions and multiple second recesses, wherein any two adjacent of the multiple second protrusions are separated by each of the multiple second recesses, and any two adjacent of the multiple second recesses are separated by each of the multiple second protrusions. The multiple second protrusions of the mold 202 correspond to the multiple first recesses of the second casing 20, and the multiple second recesses of the mold 202 correspond to the multiple first protrusions of the second casing 20. The mold 202 has two feeding holes 203 defined on the top thereof and communicating with a slit between the mold 202 and the second casing 20, wherein a thickness of the slit is 0.2 mm.

The liquid silicone rubber is fed into the mold 202 from the two feeding holes 203, wherein the mold 202 has four through apertures 204 around a peripheral wall thereof so as to accommodate four heating bars, such that after the electricity conducts to the four heating bars, the four heating bars heat the liquid silicone rubber so that the liquid silicone rubber solidifies to form the second closing film on the peripheral side of the second connection surface of the second casing 20.

In the vacuum condition, the first casing 10 is placed into a second holder, and the mold 202 is fixed on the first casing 10, the mold 202 has two feeding holes 203 defined on the top of the mold 202 so that the liquid silicone rubber is fed into the mold 202 from the two feeding holes 203, and the electricity conducts to the four heating bars so that the four heating bars heat the liquid silicone rubber, and the liquid silicone rubber solidifies to form the first closing film on the peripheral side of the first connection surface of the first casing 10. Preferably, the profile of the mold 202 corresponds to that the first casing 10, and a distance between the mold 202 and the first casing 10 is 0.2 mm.

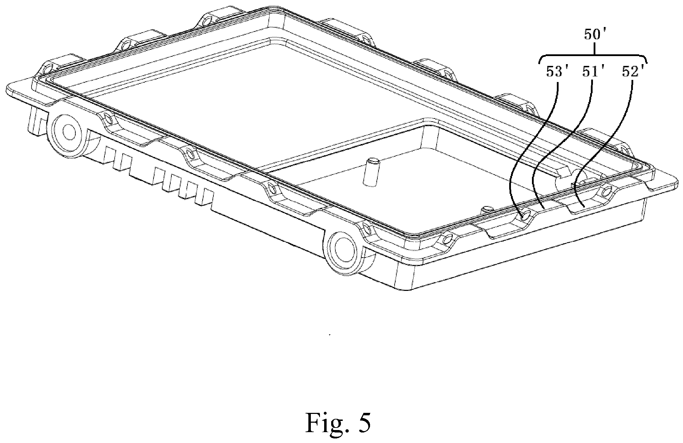

With reference to FIG. 5, a difference of a closing structure of a second embodiment from that of the first embodiment comprises: a trapezoidal locking structure 50' arranged on a peripheral side of the first connection surface of the first casing 10 and a peripheral side of the second connection surface of the second casing 20, respectively, wherein the locking structure 50' includes multiple first protrusions 51' and multiple first recesses 52', each of the multiple first protrusions 51' is in a trapezoid shape, and each of the multiple first recesses 52' is in a trapezoid shape, wherein any two adjacent of the multiple first protrusions 51' are separated by each of the multiple first recesses 52', and any two adjacent of the multiple first recesses 52' are separated by each of the multiple first protrusions 51'.

Preferably, some of the multiple first protrusions 51' on the first casing 10 retain with some of the multiple first recesses 52' on the second casing 20, and the other of the multiple first protrusions 51' on the second casing 20 retain with the other of the multiple first recesses 52' on the first casing 10, thus securely fixing the first casing 10 and the second casing 20 together.

Furthermore, each of multiple coupling orifices 53' passes through two opposite tilted walls of said each first protrusion 51'.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the spirit and scope of the invention.

## Claims

1. A closing structure for a waterproof LED lamp comprising: a first casing (10), a light power source (30), and a second casing (20);
the light power source (30) being housed in an accommodation groove of a bottom of the first casing (10), and the first casing (10) being in connection with the second casing (20);
**characterized in that**
a first closing film (41) is injection molded on a peripheral side of a first connection surface of the first casing (10) facing to the second casing (20), and a second closing film (42) is injection molded on a peripheral side of a second connection surface of the second casing (20) facing the first casing (10).

2. The closing structure as claimed in claim 1, **characterized in that** a size and a profile of the first closing film (41) correspond to those of the first casing (10), and a size and a profile of the second closing film (42) correspond to those of the second casing (20).

3. The closing structure as claimed in claim 2, **characterized in that** the first closing film (41) matingly contacts with the first connection surface of the first casing (10), and the second closing film (42) matingly contacts with the second connection surface of the second casing (20).

4. The closing structure as claimed in claim 2 or 3, **characterized in that** each of the first closing film (41) and the second closing film (42) is a silicone rubber film with a thickness of 0.2 mm.

5. The closing structure as claimed in any one of claims 1-4, **characterized in that** a rectangular locking structure (50) is arranged on a peripheral side of the first connection surface of the first casing (10) and on a peripheral side of the second connection surface of the second casing (20), respectively.

6. The closing structure as claimed in any one of claims 1-4, **characterized in that** a trapezoidal locking structure (50') is arranged on a peripheral side of the first connection surface of the first casing (10) and on a peripheral side of the second connection surface of the second casing (20), respectively.

7. The closing structure as claimed in claim 5, **characterized in that** the rectangular locking structure (50) includes multiple first protrusions (51) and multiple first recesses (52), each of the multiple first protrusions (51) is in a rectangle shape, and each of the multiple first recesses (52) is in a rectangle shape, wherein any two adjacent of the multiple first protrusions (51) are separated by each of the multiple first recesses (52), and any two adjacent of the multiple first recesses (52) are separated by each of the multiple first protrusions (51); some of the multiple first protrusions (51) on the first casing (10) retain with some of the multiple first recesses (52) on the second casing (20), and the other of the multiple first protrusions (51) on the second casing (20) retain with the other of the multiple first recesses (52) on the first casing (10).

8. The closing structure as claimed in claim 6, **characterized in that** the trapezoidal locking structure (50') includes multiple first protrusions (51') and multiple first recesses (52'), each of the multiple first protrusions (51') is in a trapezoid shape, and each of the multiple first recesses (52') is in a trapezoid shape, wherein any two adjacent of the multiple first protrusions (51') are separated by each of the multiple first recesses (52'), and any two adjacent of the multiple first recesses (52') are separated by each of the multiple first protrusions (51'); some of the multiple first protrusions (51') on the first casing (10) retain with some of the multiple first recesses (52') on the second casing (20), and the other of the multiple first protrusions (51') on the second casing (20) retain with the other of the multiple first recesses (52') on the first casing (10).

9. The closing structure as claimed in claim 7 or 8, **characterized in that** each of multiple coupling orifices (53) passes through said each first protrusion (51), and the multiple coupling orifices (53) are coaxial so that a fitting shaft (60) inserts through the multiple coupling orifices (53), thus connecting the first casing (10) and the second casing (20) together.

10. A method of making a closing structure for a waterproof LED lamp comprising steps of:
providing a first casing (10), a light power source (30), and a second casing (20);
housing the light power source (30) in an accommodation groove of the first casing (10); and
connecting the first casing (10) with the second casing (20);
**characterized in that**
the first casing (10) has a first closing film (41) injection molded on a peripheral side of a first connection surface thereof, and the second casing (20) has a second closing film (42) injection molded on a peripheral side of a second connection surface thereof.

11. The closing structure as claimed in claim 10, **characterized in that** a size and a profile of the first closing film (41) correspond to those of the first connection surface of the first casing (10), such that the first closing film (41) matingly contacts with the first connection surface of the first casing (10), and a size and a profile of the second closing film (42) correspond to those of the second connection surface of the second casing (20), hence the second closing film (42) matingly contacts with the second connection surface of the second casing (20).

12. The closing structure as claimed in claim 11, **characterized in that** the second casing (20) is placed into a first holder (201) in a vacuum condition, the second connection surface of the second casing (20) faces upwardly, and a mold (202) is mounted on the second connection surface of the second casing (20), wherein the mold (202) has at least one feeding hole (203) defined on a top thereof so that liquid silicone rubber is fed into the mold (20) from the at least one feeding holes (203), and the liquid silicone rubber is baked after conducting electricity to the mold (202), then the second closing film (42) is injection molded on the second connection surface of the second casing (20), wherein a profile of the mold (202) corresponds to that the second casing (20), and a distance between the mold (202) and the second casing (20) is 0.2 mm.

13. The closing structure as claimed in claim 11, **characterized in that** in a vacuum condition, the first casing (10) is placed into a second holder, and a mold (202) is fixed on the first casing (10), the mold (202) has at least one feeding hole (203) defined on a top thereof so that liquid silicone rubber is fed into the mold (202) from the at least one feeding hole (203), wherein the liquid silicone rubber is baked after conducting electricity to the mold (202), and the liquid silicone rubber solidifies to form the first closing film on the peripheral side of the first connection surface of the first casing (10); wherein the profile of the mold (202) corresponds to that the first casing (10), and a distance between the mold (202) and the first casing (10) is 0.2 mm.

14. The closing structure as claimed in claim 11, **characterized in that** when the first casing (10) and the second casing (20) are connected together, a thickness of the first closing film (41) and the second closing film (42) is 0.2 mm to 0.4 mm.
